# EUROPEAN PATENT APPLICATION

(11) **EP 4 343 851 A1**
(43) Date of publication of application: **27.03.2024**
(21) Application number: 23198051.7
(22) Date of filing: 18.09.2023
(51) Int. Cl.: H01L 29/45, H01L 29/47, H01L 21/285, H01L 29/778, H01L 29/20

(54) **TRANSISTOR WITH CLADDED ELECTRODES AND METHOD OF FABRICATION THEREFOR**

(30) Priority: 22.09.2022 US 202217934543
(71) Applicant: NXP USA, Inc., Austin TX 78735 (US)
(72) Inventor: Hill, Darrell Glenn, 5656AG Eindhoven (NL)
(74) Representative: Hardingham, Christopher Mark

(57) **Abstract**

A transistor device includes one or more conductive structures (120, 130, 140) on which a cladding layer (122, 132, 142) is formed, where the cladding layer has low miscibility with conductive material (124, 134, 144) of the conductive structures at temperatures below a threshold. Such conductive structures may include gate (control) electrodes (130) or drain and source (current-carrying) electrodes (120, 140). Forming such a cladded conductive structure for a transistor device may include forming photoresist layers on a substrate, selectively patterning the photoresist layers to form openings therein, forming conductive material over the photoresist layers and on the substrate in openings in the photoresist layers, and forming a cladding layer over the conductive material, then preforming a lift-off process in which the photoresist layers are removed along with portions of the conductive material and cladding layer that are not disposed in the openings in the photoresist layers.

## Description

### TECHNICAL FIELD

Embodiments of the subject matter described herein relate generally to transistor devices, and more particularly to transistor devices with molybdenum cladded structures.

### BACKGROUND

Field effect transistor (FET) devices find application in a wide variety of electronic components and systems. While various advances have been made to improve gain, efficiency, and other characteristics of power FETs that are used to provide amplification in radio frequency (RF) communication systems, challenges still exist for fabricating such devices. For example, conventional FETs that utilize gold metallization to form conductive structures of such FETs may have degraded electrical conductivity due to gold reactivity with certain other metals at relatively low temperatures. As gold is a relatively soft metal, it is easily deformed by mechanical forces, resulting in higher incidence of mechanical deformation of conventional FET structures that are formed primarily or entirely from gold.

### SUMMARY

A brief summary of various exemplary embodiments is presented below. Some simplifications and omissions may be made in the following summary, which is intended to highlight and introduce some aspects of the various exemplary embodiments, without limiting the scope. Detailed descriptions of an exemplary embodiment adequate to allow those of ordinary skill in the art to make and use these concepts will follow in later sections.

In an example embodiment, a transistor device may include a semiconductor substrate having an upper surface, a control electrode disposed on the upper surface of the semiconductor substrate, a first current-carrying electrode disposed on the upper surface of the semiconductor substrate, and a second current-carrying electrode disposed on the upper surface of the semiconductor substrate. At least one of the control electrode, the first current-carrying electrode, or the second current-carrying electrode may include conductive material that is coated with a cladding material. The cladding material may have low miscibility with the conductive material.

In one or more embodiments, the control electrode may include the conductive material.

In one or more embodiments, each of the control electrode, the first current-carrying electrode, and the second current-carrying electrode may include the conductive material.

In one or more embodiments, the conductive material may include gold and the cladding layer may include molybdenum.

In one or more embodiments, the cladding layer may have a thickness of less than 400 angstroms.

In one or more embodiments, the cladding layer may be formed on an upper surface and side surfaces of the conductive material.

In one or more embodiments, the semiconductor substrate may include a host substrate, a buffer layer having first semiconductor material formed over the host substrate, a channel layer having second semiconductor material formed over the buffer layer, and a barrier layer having third semiconductor material formed over the channel layer. Each of the control electrode, the first current-carrying electrode, and the second current-carrying electrode may overlap the channel layer. The upper surface of the semiconductor substrate may correspond to an upper surface of the barrier layer.

In an example embodiment, a method may include steps of forming at least one patterned photoresist layer on an upper surface of a semiconductor substrate, forming conductive material having first portions formed on the at least one patterned photoresist layer and second portions in openings in the at least one patterned photoresist layer, the second portions contacting the upper surface of the semiconductor substrate, and forming a cladding layer on the conductive material. The cladding material may be harder than the conductive material.

In one or more embodiments, the method may include a step of simultaneously removing each of the at least one patterned photoresist layer, the first portions of the conductive material, and first portions of the cladding layer that are disposed on the first portions of the conductive material via a lift-off process.

In one or more embodiments, the at least one patterned photoresist layer may include a first patterned photoresist layer disposed on the upper surface of the semiconductor substrate and a second patterned photoresist layer disposed on the first patterned photoresist layer, and the second patterned photoresist layer may overhang the first patterned photoresist layer at each of the openings.

In one or more embodiments, the first portions of the conductive material and portions of the cladding layer formed on the first portions of the conductive material may correspond to control electrodes of transistor devices.

In one or more embodiments, the cladding layer may have a thickness of less than 400 angstroms.

In one or more embodiments, the conductive material may include gold, and the cladding layer may include molybdenum that is formed directly on the gold of the conductive material.

In one or more embodiments, forming the cladding layer on the conductive material may include depositing the cladding layer on an upper surface and side surfaces of the conductive material via evaporation.

As further disclosed herein, a transistor device may include a semiconductor substrate having a channel layer, and a control electrode having first conductive material and a first cladding layer formed on the first conductive material, the control electrode disposed over the channel layer of the semiconductor substrate, and the first cladding layer having low miscibility with respect to the first conductive material.

The first cladding layer may be formed on an upper surface and side surfaces of the first conductive material of the control electrode.

The first conductive material may include gold, the first cladding material may include molybdenum, and the first conductive material may directly contact the first cladding material.

The transistor device includes a first current-carrying electrode disposed over the channel layer of the semiconductor substrate, and a second current-carrying electrode disposed over the channel layer of the semiconductor substrate. The first current-carrying electrode may include second conductive material and a second cladding layer disposed directly on the second conductive material. The second current-carrying electrode may include third conductive material and a third cladding layer disposed directly on the third conductive material. The second cladding layer may have low miscibility with respect to the second conductive material. The third cladding layer may have low miscibility with respect to the third conductive material.

The second conductive material may include gold, the second cladding layer may include molybdenum, the third conductive material may include gold, and the third cladding layer may include molybdenum.

The first cladding layer may include a thickness of less than 400 angstroms.

### BRIEF DESCRIPTION OF THE DRAWINGS

A more complete understanding of the subject matter may be derived by referring to the detailed description and claims when considered in conjunction with the following figures, wherein like reference numbers refer to similar elements throughout the figures.
FIG. 1 is a cross-sectional side view an illustrative transistor device, in accordance with various embodiments.
FIG. 2 is a process flow diagrams describing a method for fabricating a molybdenum-cladded structure, such as respective gate, drain, or source electrodes of transistor devices such as the transistor device of FIG. 1, in accordance with various embodiments.
FIGS. 3-10 are cross sectional views depicting stages of fabrication of molybdenum-cladded structures, such as respective gate, drain, or source electrodes of transistor devices such as the transistor device of FIG. 1, in accordance with various embodiments.

### DETAILED DESCRIPTION

Various embodiments described herein address the above challenges by providing a transistor device and an associated fabrication method in which one or more electrically conductive structures, such as control (e.g., gate) electrodes or current-carrying (e.g., source or drain) electrodes, are cladded with a layer of molybdenum. For example, such conductive structures may have a layer of molybdenum disposed on their upper surfaces and side surfaces. The molybdenum layer may be less than 400 angstroms thick or less than 100 angstroms thick (e.g., around 45 to 55 angstroms thick) in some embodiments. In one or more embodiments, conductive structures may include gold and the molybdenum layer may be disposed directly in contact with the gold of the conductive structures. In one or more embodiments, a molybdenum layer may be formed on conductive material (e.g., gold) of the conductive structures using a method by which the conductive material and the molybdenum layer are formed using selective deposition (e.g., evaporation, chemical vapor deposition, sputtering, or another suitable process in conjunction with photolithography), which is followed by a lift-off process that removes photoresist along with excess molybdenum and conductive material.

By cladding (i.e., coating, covering) surfaces of one or more conductive structures of a transistor with a layer of molybdenum, such structures may be better protected against mechanical deformation. For example, molybdenum has a Vickers hardness value of around 230, whereas gold has a Vickers hardness value of around 25, meaning that molybdenum is significantly harder than gold. By cladding a conductive structure that is at least partially formed of a relatively softer material, such as gold, with a relatively thin layer of molybdenum (e.g., less than 400 angstroms thick), mechanical deformation that might otherwise occur due to deformation of the softer material may be mitigated.

Additionally, some materials (e.g., titanium) have a relatively low temperature (e.g., around 200 °C in the case of titanium) at which they interact with gold. Such materials may alloy with gold in conductive structures of a transistor, resulting in an undesirable increase in the resistivity of such conductive structures, which may negatively impact transistor performance. In contrast, molybdenum and gold have little or no miscibility below 1054 °C. The likelihood of alloying occurring at the interface between the molybdenum layer and gold of a conductive structure of a transistor device is, therefore, relatively low. Thus, by using molybdenum as the cladding material for conductive structures of a transistor device, the risk of increased conductive structure resistivity due to alloying may be mitigated.

It should be noted that the examples provided herein of cladding gold conductive structures with molybdenum are intended to be illustrative and not limiting. For example, similar protection against mechanical deformation via cladding may also be provided for conductive transistor structures that include relatively soft conductive materials other than gold with cladding materials that are immiscible or that have low miscibility with such conductive materials, such as tungsten, osmium, ruthenium, iridium, rhodium, or chromium as non-limiting examples.

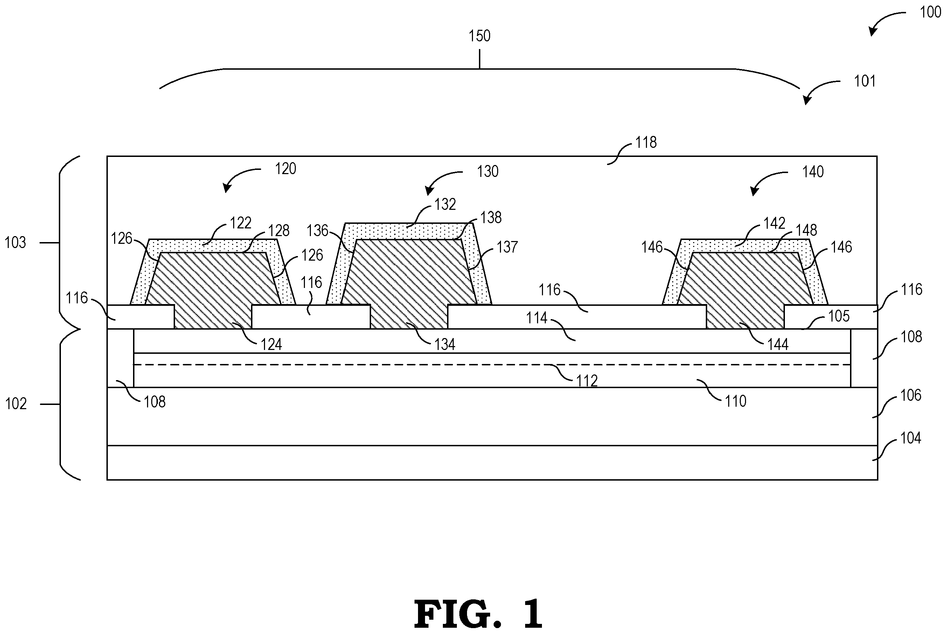

FIG. 1 is a cross-sectional side view of an embodiment of a transistor device 100. The transistor device 100 includes a semiconductor die having a base semiconductor substrate 102 (sometimes referred to herein as the "substrate 102" or "the semiconductor substrate 102") and an overlying build-up structure 103. The substrate 102 includes an upper surface 105. A plurality of additional electrical structures, patterned conductive layers, and dielectric layers are included in the build-up structure 103, which is connected to and overlies the upper surface 105 of the substrate 102.

In some embodiments, an active region 150 is defined within a portion of the substrate 102 and an overlying portion of the build-up structure 103. One or more isolation regions 108 may be defined within the substrate 102 at the upper surface 105, and the active region 150 corresponds to portions of the substrate 102 extending between at least two of the isolation regions 108.

In some embodiments, the semiconductor substrate 102 may include a host semiconductor substrate 104 and a plurality of layers overlying the host substrate 104. According to an embodiment, the plurality of layers overlying the host substrate 104 includes a buffer layer 106, a channel layer 110, and a barrier layer 114, all of which are described in more detail below.

In some embodiments, the build-up structure 103 is formed on and over the upper surface 105 of the substrate 102 and may include various electrical structures (e.g., gate electrode 130, source and drain electrodes 120, 140), one or more dielectric layers (e.g., passivation layer(s) 116, dielectric layer(s) 118), and one or more patterned conductive layers (not shown; e.g., source metallization, field plates, interconnects, or other applicable conductive layers).

At least one transistor 101 is formed in the active region 150 of the transistor device 100. In various embodiments, the transistor 101 is a field effect transistor (FET), which includes a gate electrode 130, a source electrode 120 proximate to but spaced apart from a sidewall (i.e., the sidewall 136) of the gate electrode 130, and a drain electrode 140 proximate to but spaced apart from the opposite sidewall (i.e., the sidewall 137) of the gate electrode 130, each of which are disposed at the upper surface 105 of the substrate 102 and are formed in the build-up structure 103 overlying the substrate 102. In some embodiments, the transistor 101 is a high electron mobility transistor (HEMT), although the transistor 101 may be another type of transistor in one or more other embodiments. In some embodiments, the transistor 101 is a gallium nitride (GaN) HEMT.

In one or more embodiments, the transistor device 100 includes multiple transistors that may be similar to the transistor 101. Such transistors may be arranged in parallel with respect to one another, for example.

The source and drain electrodes 120, 140 (sometimes referred to as first and second current-carrying electrodes, respectively) may be formed at and over the upper surface 105 of the substrate 102. In some embodiments, the source and drain electrodes 120, 140 make ohmic contact with the substrate 102. For example, the source electrode 120 and the drain electrode 140 may be formed laterally adjacent each other, and both of the source electrode 120 and the drain electrode 140 extend through the passivation layer 116 to make contact with the upper surface 105 of the substrate 10. In addition, the source and drain electrodes 120, 140 may be electromagnetically coupled to opposite ends of a channel 112, which is present within the channel layer 110 of the substrate 102. In one or more embodiments, the source electrode 120 may be electrically coupled to a conductive ground plane (not shown) formed at a backside of the substrate 102 by, for example, a through substrate via (TSV) that may be coupled between the source electrode 120 and the conductive ground plane. The drain electrode 140 may be electrically coupled to an output (not shown) of the transistor device 100 via one or more interconnects disposed in the substrate 102 and/or in the build-up structure 103.

The source electrode 120 may include conductive material 124 and a cladding layer 122 disposed on an upper surface 128 and sidewalls 126 (i.e., side surfaces) of the conductive material 124. That is, the conductive material 124 may be covered by the cladding layer 122. In one or more embodiments, the cladding layer 122 is formed from molybdenum, such that the source electrode 120 is a molybdenum-cladded conductive structure. In one or more embodiments, the conductive material 124 includes gold, and the cladding layer 122 directly contacts the gold of the conductive material 124.

The drain electrode 140 may include conductive material 144 and a clading layer 142 disposed on an upper surface 148 and sidewalls 146 (i.e., side surfaces) of the conductive material 144. That is, the conductive material 144 may be covered by the cladding layer 142. In one or more embodiments, the cladding layer 122 is formed from molybdenum, such that the drain electrode 140 is a molybdenum-cladded conductive structure. In one or more embodiments, the conductive material 144 includes gold, and the caldding layer 142 directly contacts the gold of the conductive material 144.

The gate electrode 130 (sometimes referred to herein as a "control electrode") may be a conductive (i.e., electrically conductive) structure, which is electromagnetically coupled to the channel 112 in one or more embodiments. According to an embodiment, the gate electrode 130 extends through the passivation layer 116 to contact the upper surface 105 of the substrate 102 between the source and drain electrodes 120, 140. The gate electrode 130 may include conductive material 134 and a cladding layer 132 disposed on an upper surface 138 and sidewalls 136, 137 (i.e., side surfaces) of the conductive material 134. That is, the conductive material 134 may be covered by the cladding layer 132. In one or more embodiments, the cladding layer 122 is formed from molybdenum, such that the gate electrode 130 is a molybdenum-cladded conductive structure. In one or more embodiments, the conductive material 134 includes gold, and the cladding layer 132 directly contacts the gold of the conductive material 134.

In one or more embodiments, the build-up structure 103 includes the passivation layer 116, the source electrode 120, the gate electrode 130, the drain electrode 140, and the one or more dielectric layers 118. As mentioned above, the gate electrode 130 may extend through openings in the passivation layer 116. Each of the source electrode 120, the gate electrode 130, and the drain electrode 140 contact the upper surface 105 of the substrate 102 at various points above the channel 112.

In one or more embodiments, the passivation layer 116 and the dielectric layers 118 may respectively include one or more layers formed one or more dielectric materials such as aluminum oxide (Al₂O₃), silicon nitride (SiN; sometimes given as Si₃N₄), silicon oxide (SiO₂), silicon oxynitride (SiON), aluminum nitride (AlN), silicon aluminum nitride (SiAlN), hafnium oxide (HfO₂), zirconium oxide (ZrO₂), titanium oxide (TiO₂), or other suitable dielectric materials. In some embodiments, each of the passivation layer 116 and the dielectric layers 118 are deposited over the substrate 102 using respective chemical vapor deposition processes, such as low-pressure chemical vapor deposition (LPCVD) or plasma-enhanced chemical vapor deposition (PECVD).

In an embodiment, the host substrate 104 of the semiconductor substrate 102 may be formed from silicon carbide (SiC). In other embodiments, the host substrate 104 may include other materials such as sapphire, silicon (Si), gallium nitride (GaN), aluminum nitride (AlN), diamond, boron nitride (BN), poly-SiC, silicon on insulator, gallium arsenide (GaAs), indium phosphide (InP), or other suitable semiconductor materials.

The buffer layer 106 may be formed on the host substrate 104. The buffer layer 106 may include one or more group III-nitride semiconductor layers. In some embodiments, the buffer layer 106 includes multiple layers of semiconductor material, where each of the layers of buffer layer 106 may include an epitaxially grown group-III nitride layer, for example. In such embodiments, the epitaxially grown group-III nitride layers of the buffer layer 106 may include nitrogen (N)-polar (i.e., N-face) or gallium (Ga)-polar (i.e., Ga-face) material, for example. In one or more other embodiments, the semiconductor layer(s) of the buffer layer 106 may not be epitaxially grown. In still other embodiments, the semiconductor layer(s) of the buffer layer 106 may include Si, GaAs, InP, or other suitable materials.

In some embodiments, the buffer layer 106 may include at least one AlGaN mixed crystal layer having a composition denoted by AlxGai-xN with an aluminum mole fraction, X, that can take on values between 0 and 1. The total thickness of buffer layer 106, including all of its constituent layers, may be between about 100 angstroms and about 100,000 angstroms although other thicknesses may be used. A limiting X value of 0 yields pure GaN while a value of 1 yields pure aluminum nitride (AlN). In an embodiment, the buffer layer 106 may include a nucleation region comprised of AlN. The nucleation region starts at the interface between the host substrate 104 and buffer layer 106 and may extend about 100 angstroms to about 1000 angstroms into buffer layer 106. The buffer layer 106 may include additional AlxGai-xN layers formed over the nucleation region. The thickness of the additional AlxGai-xN layer(s) may be between about 100 angstroms and about 50,000 angstroms though other thicknesses may be used. In an embodiment, the additional Al_{X}Ga_{1-X}N layer(s) may be configured as GaN layer(s) (X=0) where the AlxGai-xN layer(s) are not intentionally doped (NID). Alternatively, the additional AlxGai-xN layer(s) may be configured as one or more GaN layers where the one or more GaN layers are intentionally doped with dopants that may include iron (Fe), chromium (Cr), carbon (C) or other suitable dopants that render buffer layer 106 substantially insulating or highly resistive. The dopant concentration may be between about 10¹⁷ cm⁻³ and 10¹⁹ cm⁻³ though other higher or lower concentrations may be used. The additional AlxGai-xN layers may be configured with X=0.01 to 0.10 where the AlxGaixN is NID or, alternatively, where the Al_{X}Ga₁₋xN is intentionally doped with Fe, Cr, C, a combination of these, or other suitable dopant species. In one or more other embodiments, the additional Al_{X}Ga_{1-X}N layers may be configured as a superlattice where the additional AlxGai-xN layers include a series of alternating NID or doped Al_{X}Ga_{1-X}N layers where the value of X takes a value between 0 and 1. In still other embodiments, buffer layer 106 may include one or more indium gallium nitride (InGaN) layers, with composition denoted In_{Y}Ga_{1-Y}N, where Y, the indium mole fraction, may take a value between 0 and 1. The thickness of the InGaN layer(s) may be between about 10 angstroms and about 1000 angstroms though other thicknesses may be used.

In an embodiment, the channel layer 110 may be formed over buffer layer 106. The channel layer 110 may include one or more group III-nitride semiconductor layers. The channel layer 110 may include an Al_{X}Ga_{1-X}N layer where X takes on values between 0 and 1. n an embodiment, the channel layer 110 is configured as GaN (X=0) although other values of X may be used. The thickness of the channel layer 110 may be between about 50 angstroms and about 10,000 angstroms, though other thicknesses may be used. The channel layer 110 may be NID or, alternatively, may include Si, Ge, C, Fe, Cr, or other suitable dopants. The dopant concentration may be between about 10¹⁶ and about 10¹⁹ cm⁻³ though other higher or lower concentrations may be used. In other embodiments, channel layer 110 may include NID or doped In_{Y}Ga_{1-Y}N, where Y, the indium mole fraction, may take a value between 0 and 1.

The barrier layer 114 may be formed over the channel layer 110, in accordance with an embodiment. The barrier layer 114 may include one or more group III-N semiconductor layers. The barrier layer 114 may have a larger bandgap and/or larger spontaneous polarization than the channel layer 110 and, when the barrier layer 114 is over channel layer 110, the channel 112 may be created in the form of a two-dimensional electron gas (2-DEG) within channel layer 110 adjacent the interface between the channel layer 110 and the barrier layer 114. In addition, tensile strain between the barrier layer 114 and channel layer 110 may cause additional piezoelectric charge to be introduced into the 2-DEG and the channel 112. The barrier layer 114 may include a multi-layer structure, where the first layer of the barrier layer 114 may include at least one NID AlxGai-xN layer where X takes on values between 0 and 1. In some embodiments, X may take a value of 0.1 to 0.35, although other values of X may be used. The thickness of the first layer of the barrier layer 114 may be between about 50 angstroms and about 1000 angstroms though other thicknesses may be used. The barrier layer 114 may be NID or, alternatively, may include Si, Ge, C, Fe, Cr, or other suitable dopants. The dopant concentration may be between about 10¹⁶ and 10¹⁹ cm⁻³ though other higher or lower concentrations may be used.

An additional AlN interbarrier layer (not shown) may be formed between the channel layer 110 and the barrier layer 114, in some embodiments. The AlN interbarrier layer may introduce additional spontaneous and piezoelectric polarization, increasing the channel charge and improving the electron confinement of the resultant 2-DEG that forms the channel 112.

In other embodiments, the barrier layer 114 may include one or more indium aluminum nitride (InAlN) layers, denoted In_{Y}Al_{1-Y}N, where Y, the indium mole fraction, may take a value between about 0.1 and about 0.2 though other values of Y may be used. In the case of using InAlN to form the barrier layer 114, the thickness of the barrier layer 114 may be between about 50 angstroms and about 1000 angstroms though other thicknesses may be used. In the case of using InAlN to form the barrier layer 114, the InAlN may be NID or, alternatively, may include Si, Ge, C, Fe, Cr, or other suitable dopants. The dopant concentration may be between about 10¹⁶ cm⁻³ and about 10¹⁹ cm⁻³ though other higher or lower concentrations may be used.

In some embodiments, a cap layer (not shown) may be formed over the barrier layer 114. When included, the cap layer presents a stable surface for the substrate 102 and serves to protect the upper surface 105 of the substrate 102 from chemical and environmental exposure incidental to wafer processing. The cap layer may include one or more group III-N semiconductor layers and is supported by the barrier layer 114. In an embodiment, the cap layer includes GaN. The thickness of the cap layer may be between about 5 angstroms and about 100 angstroms though other thicknesses may be used. The cap layer may be NID or, alternatively, may include Si, Ge, C, Fe, Cr, or other suitable dopants. The dopant concentration may be between about 10¹⁶ cm⁻³ and 10¹⁹ cm⁻³ though other higher or lower concentrations may be used.

The isolation regions 108 may be formed via an implantation procedure configured to damage the epitaxial and/or other semiconductor layers to create high resistivity regions of the substrate 102, rendering the substrate 102 high resistivity or semi-insulating in the high resistivity regions while leaving the crystal structure intact in the active region 150. In other embodiments (not shown), one or more of the isolation regions 108 may be formed by removing portions of one or more of the epitaxial and/or other semiconductor layers of the substrate 102 and leaving behind active region "mesas", such as the active region 150, surrounded by the isolation regions 108 (i.e., surrounded by regions of high resistivity or semi-insulating material).

By cladding conductive structures, such as the source electrode 120, the gate electrode 130, and the drain electrode 140, of the transistor 101 with cladding material (e.g., the cladding layers 122, 132, 142) having hardness above a threshold (e.g., a threshold of around 5 or higher on the Mohs hardness scale or a threshold of around 5.5 or higher on the Mohs hardness scale, according to various embodiments), mechanical damage or deformation of such structures (e.g., which often occurs during lift-off processes, potentially causing non-negligible product yield loss) may be prevented or mitigated. Such mechanical damage and deformation prevention may be more effective for embodiments in which the conductive material 124, 134, 144 includes material that is softer than the cladding material, such as embodiments in which the cladding material is molybdenum and the conductive material is gold.

By cladding conductive structures, such as the source electrode 120, the gate electrode 130, and the drain electrode 140 of the transistor 101 with cladding material (e.g., the cladding layers 122, 132, 142) having relatively low miscibility with the material of these conductive structures at temperatures below a threshold (e.g., a threshold of at least around 300 °C or a threshold of at least around 500 °C, according to various embodiments), intermixing (e.g., alloying) between the material of the conductive structures and the cladding material may be reduced, which may advantageously mitigate or prevent reductions in electrical conductivity associated with such intermixing or alloying. Herein, two conductive materials may be considered to have "low miscibility" with respect to one another within a given temperature range if, within that temperature range, interaction at interfaces between the two conductive materials results in degradation (i.e., reduction) of electrical conductivity in both conductive materials, where the amount of degradation is less than a threshold (e.g., a threshold of around a 10% reduction in electrical conductivity, a threshold of around a 5% reduction in electrical conductivity, or a threshold of around a 1% reduction in electrical conductivity, according to various embodiments).

As an example, for embodiments in which one or more conductive structures of the transistor 101 (e.g., the conductive material 124, 134, 144) includes gold, by cladding such conductive structures with molybdenum (e.g., the cladding layers 122, 132, 142, respectively), alloying between the cladding material (molybdenum) and the conductive material (gold) of the conductive structures may be prevented or mitigated. For example, such alloying may be prevented or mitigated due to interactions between molybdenum and gold being negligible at temperatures below 1054 °C.

While many of the preceding examples describe the conductive materials 126, 136, 146 cladded with the cladding layers 122, 132, 142, respectively, as corresponding to gold cladded with molybdenum it should be understood that in one or more other embodiments, materials other than molybdenum that have either or both of higher hardness or low miscibility with respect to the conductive materials 126, 136, 146 (e.g., with gold) may instead be used, such as tungsten, osmium, ruthenium, iridium, rhodium, or chromium as non-limiting examples.

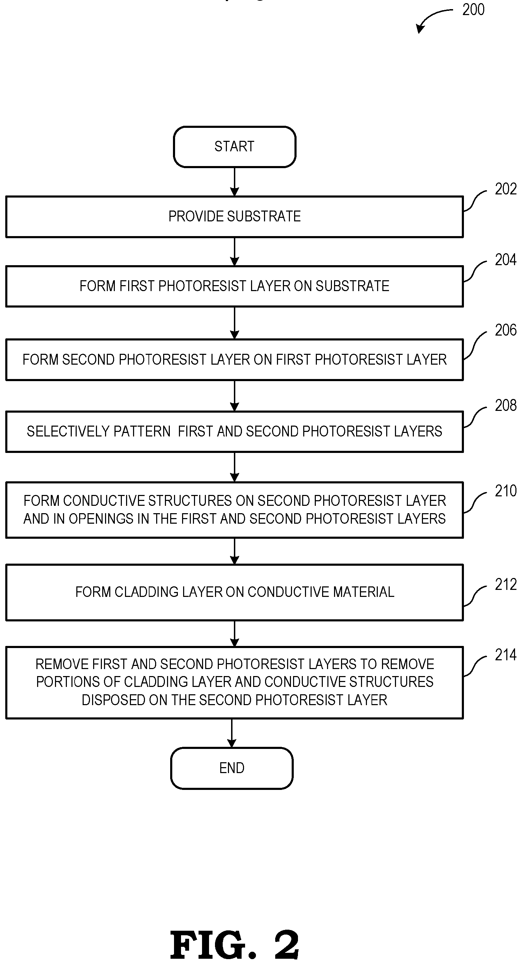

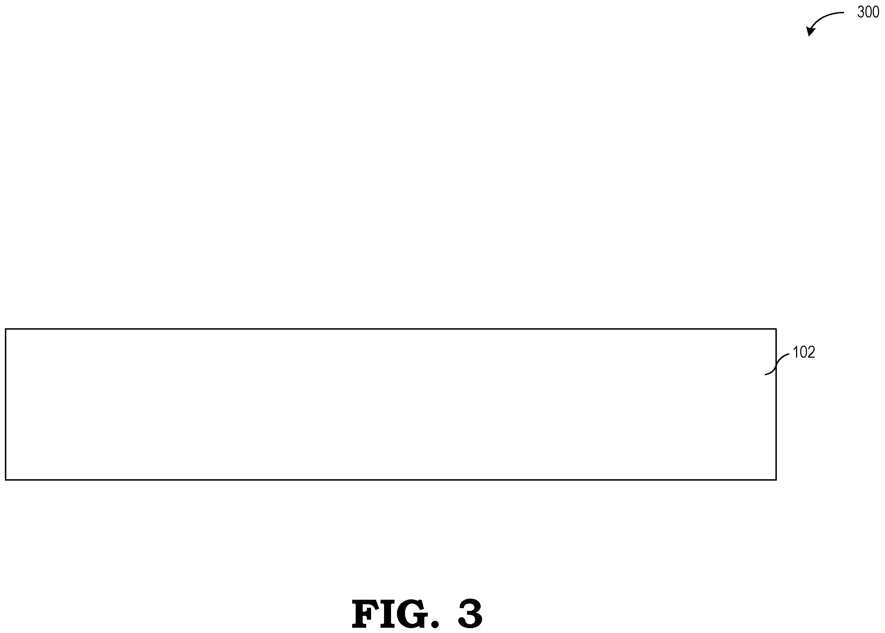

FIG. 2 is a process flow diagram depicting a method 200 for fabricating conductive structures (e.g., any of the source electrode 120, the gate electrode 130, or the drain electrode 140 of FIG. 1) of one or more transistors of a transistor device, such as the transistor device 100 of FIG. 1, in accordance with various embodiments. For enhanced understanding, FIG. 2 may be viewed simultaneously with FIGS. 3-9, which are cross sectional views depicting one or more embodiments of the transistor device 101 of FIG. 1 at various stages of fabrication. For example, the views shown in FIGS. 3-9 may correspond to fabrication of conductive structures (e.g., gate electrodes, source electrodes, or drain electrodes as non-limiting examples) of multiple transistors of in the transistor device 101.

Referring first to step 202 of FIG. 2 and to FIG. 3, at a first stage of fabrication 300, a semiconductor substrate 102 is provided. As mentioned previously, the semiconductor substrate 102 may include a host substrate 104 and a buffer layer 106, a channel layer 110, and a barrier layer 114 overlying the host semiconductor substrate 104 (as shown in FIG. 1).

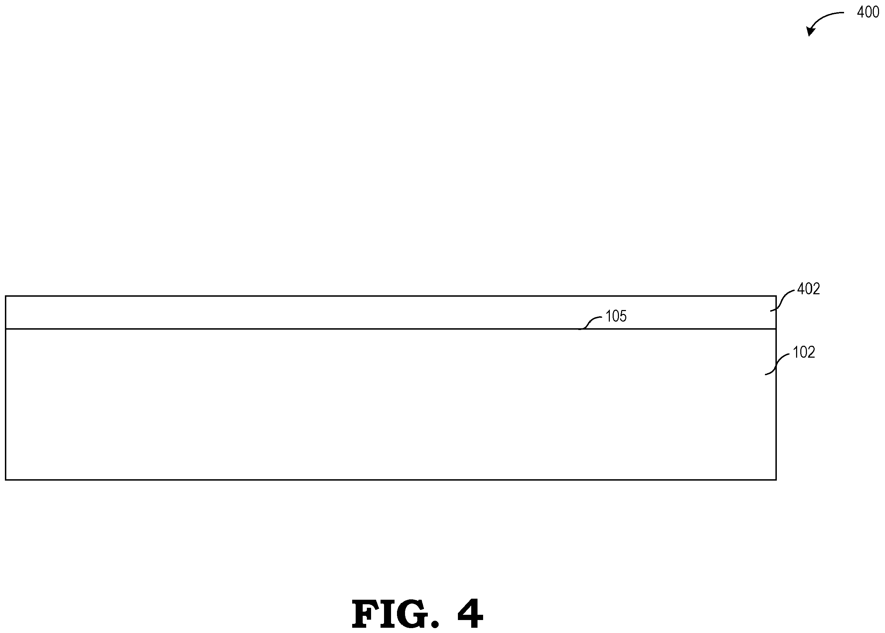

Referring next to step 204 of FIG. 2 ("form first photoresist layer on substrate") and to FIG. 4, during a stage of fabrication 400, a first photoresist layer 402 is formed on the upper surface 105 of the semiconductor substrate 102. For example, the first photoresist layer 402 may be formed via application of photoresist material at a substantially even thickness (e.g., via spin-coating) over the substrate 102. Herein, "photoresist material" refers to light sensitive material that may be degraded (in the case of positive photoresist material) or polymerized or crosslinked (in the case of negative photoresist material) by ultraviolet (UV) light. An example of positive photoresist material may include a mixture of diazonaphthoquinone (DNQ) and a phenol formaldehyde resin (e.g., Novolac resin). Examples of negative photoresist materials may include epoxy-based polymers, off-stoichiometry thiol-enes (STE) polymers, and hydrogen silsesquioxane (HSQ).

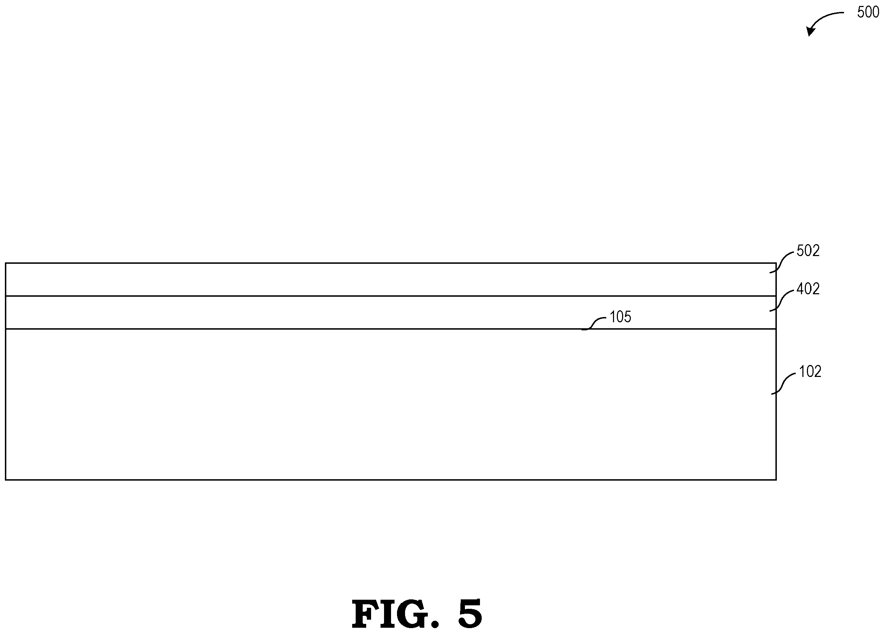

Referring next to step 206 of FIG. 2 ("form second photoresist later on first photoresist layer") and to FIG. 5, during a stage of fabrication 500, a second photoresist layer 502 is formed over the first photoresist layer 402. For example, the second photoresist layer 502 may be formed via application of photoresist material at a substantially even thickness (e.g., via spin-coating) over the first photoresist layer 402.

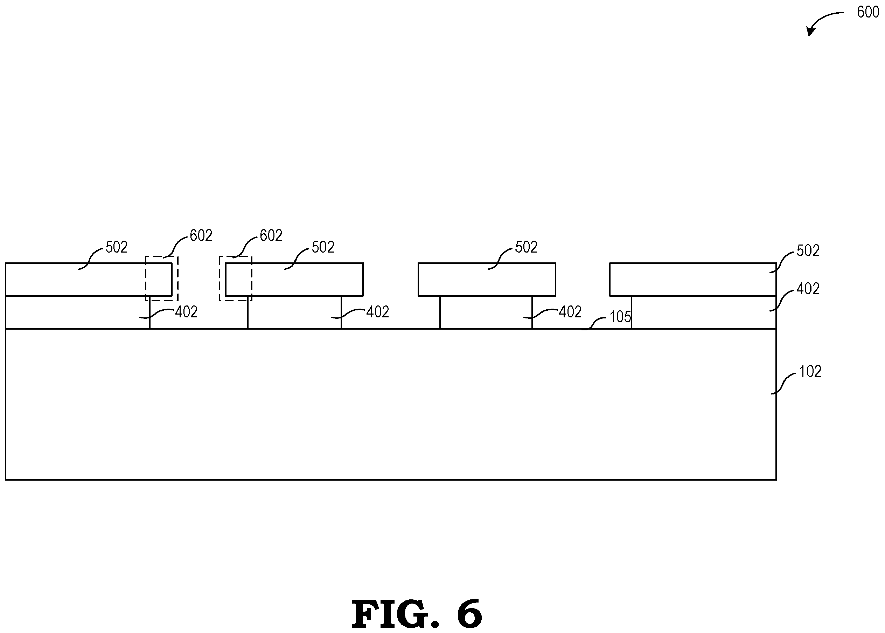

Referring to step 208 of FIG. 2 ("selectively pattern first and second photoresist layers") and to FIG. 6, during a stage of fabrication 600, the first photoresist layer 402 and the second photoresist layer 502 are selectively patterned using a lithographic process in which a patterned mask is placed over the photoresist material while UV light is provided to cure portions of the photoresist material that are exposed to the UV light through openings in the patterned mask. A photoresist stripper chemical (e.g., solvent, alkaline media, or other suitable substances) is then applied to the photoresist material to remove portions of the photoresist material (e.g., the portions exposed to the UV light if positive photoresist material is used or the potions not exposed to the UV light if negative photoresist material is used). As shown, the first photoresist layer 402 and the second photoresist layer 502, after patterning, each include openings through which portions of the surface 105 of the substrate 102 are exposed.

For example, one or more openings in the second photoresist layer 502 may overlap openings of the first photoresist layer 402, such that the surface 105 of the substrate 102 is exposed through both sets of openings. As shown, portions of the second photoresist layer 502, such as the portions 602, may overhang the first photoresist layer 402 at such openings. That is, the portions 602 of the second photoresist layer 502 at a given opening extend toward a central axis (i.e., a central axis aligned normal to the surface 105) of the opening to a greater extent than do corresponding portions of the first photoresist layer 402.

The first photoresist layer 402 and the second photoresist layer 502 may be formed from respectively different photoresist materials, resulting in the overhanging portions 602 of the second photoresist layer 502. In one or more embodiments, the first photoresist layer 402 is formed from a first photoresist material having a first sensitivity to light and the second photoresist material 502 is formed from a second photoresist material having a second sensitivity to light that is higher than that of the first photoresist material. In such embodiments, the greater light sensitivity of the first photoresist layer 402 may cause overexposure of UV-exposed portions of the first photoresist layer 402 during the lithographic process, which causes more of the first photoresist layer 402 than the second photoresist layer 502 being removed when forming the openings, resulting in the portions 602 overhanging the first photoresist layer 402 at the openings.

In one or more other embodiments, the first photoresist layer 402 is formed from a first photoresist material having a first dissolution rate (with respect to the solvent used to remove exposed photoresist during the lithographic process) and the second photoresist material 502 is formed from a second photoresist material having a second dissolution rate that is lower than that of the first photoresist material. In such embodiments, the greater dissolution rate of the first photoresist layer 402 may cause exposed portions of the first photoresist layer 402 to be dissolved more quickly than those of the second photoresist layer 502 when forming the openings during the lithographic process, resulting in the portions 602 overhanging the first photoresist layer 402 at the openings.

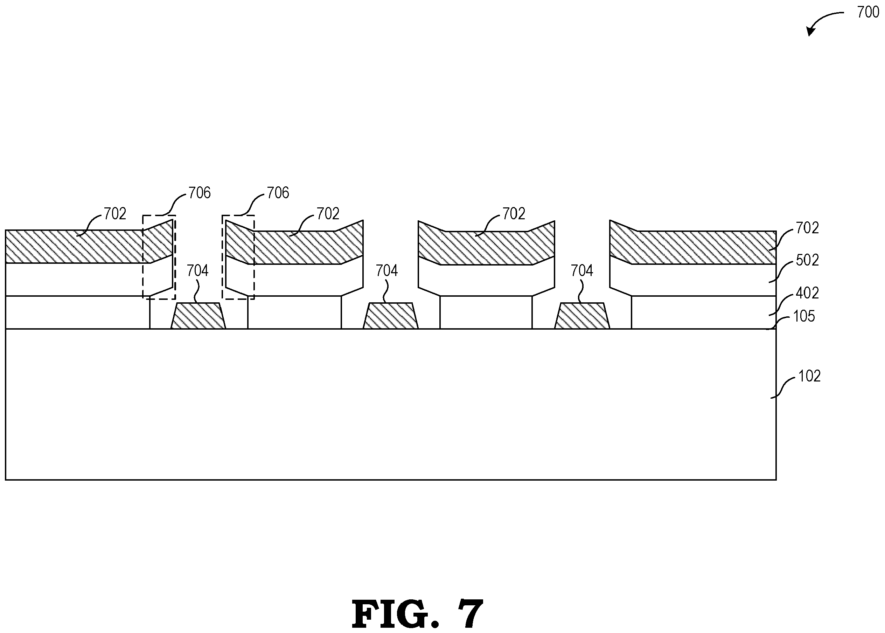

Referring to step 210 of FIG. 2 ("form conductive structures on second photoresist layer and in openings in the first and second photoresist layers") and to FIG. 7, during a stage of fabrication 700, conductive structures, including first conductive structures 702 and second conductive structures 704, is formed over the substrate 102. For example, the first conductive structures 702 and the second conductive structures 704 may be concurrently formed via evaporation, sputtering, chemical vapor deposition, or another suitable process. The first conductive structures 702 may be formed on (e.g., directly in contact with) the second photoresist layer 502. The second conductive structures 704 may be formed on (e.g., directly on the upper surface 105) of the substrate 102. The first and second conductive structures 702 and 704 may be formed from the same conductive material, which may be deposited or evaporated during a single processing step. That is, the first conductive structures 702 may be formed concurrently with the second conductive structures 704. For example, each of the first conductive structures 702 and the second conductive structures 704 may have respective thicknesses of between around 1000 Å and around 10000 Å.

In one or more embodiments, the first conductive structures 702 and the second conductive structures 704 may each include relatively soft conductive material (e.g., softer than molybdenum; having a Mohs hardness of less than around 5), such as gold. In one or more embodiments, side surfaces (e.g., side surfaces 126, 136, 137, 146, FIG. 1) of each of the second conductive structures 704 may be slanted with respect to the substrate 102 (e.g., around 10 or more degrees from normal with respect to the surface 105 of the substrate 102), which may improve subsequent deposition of material (e.g., molybdenum) on these side surfaces.

The formation of the first conductive structures 702 on the second photoresist layer 502 may cause deformation in overhanging portions (i.e., overhanging corresponding portions of the first photoresist layer 402 at the openings), of the second photoresist layer 502 and the first conductive structures 702, such as portions 706. For example, such overhanging portions of the second photoresist layer 502 and the first conductive structures 702 may bend away from the substrate 102 due to this deformation. This widens the openings in the second photoresist layer 502 and the first conductive structures 702, such that subsequently deposited material may be formed on sidewalls (i.e., side surfaces) of the second conductive structures 704 in addition to the upper surfaces of the second conductive structures 704.

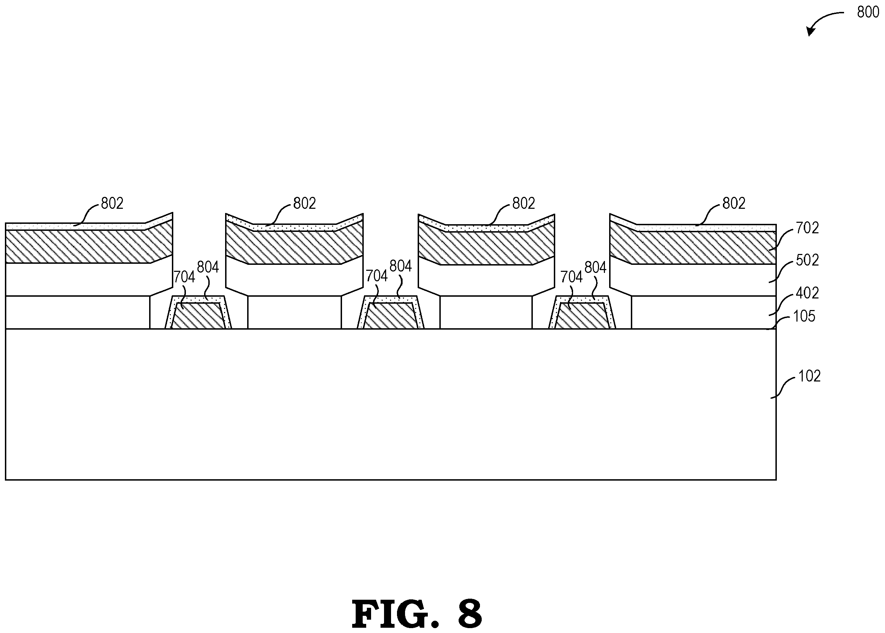

Referring to step 212 of FIG. 2 ("form cladding layer on conductive material") and to FIG. 8, during a stage of fabrication 800, cladding material, such as molybdenum is formed over the substrate 102. For example, the cladding material may include a first molybdenum layer 802 (sometimes referred to as a "first cladding layer 802") and a second molybdenum layer 804 (sometimes referred to as a "second cladding layer 804") is formed (e.g., deposited or evaporated) over the substrate 102. The first molybdenum layer 802 may be formed on (e.g., directly on) the first conductive structures 702. The second molybdenum layer 804 may be formed on (e.g., directly on) the second conductive structures 702. The first molybdenum layer 802 may be formed concurrently with the second molybdenum layer 804 in the same processing step (e.g., in the same evaporation or deposition step). The second molybdenum layer 804 may be disposed on upper surfaces and side surfaces of the second conductive structures 704, such that the second molybdenum layer 804 coats second conductive structures 704. That is, the second conductive structures 704 may be cladded by the second molybdenum layer 804. The first and second molybdenum layers 802, 804 may have respective thicknesses of less than 400 angstroms or less than 100 angstroms (e.g., between around 45 angstroms and 55 angstroms in one or more embodiments). In one or more embodiments, all or substantially all surfaces of the second conductive structures 704 that are not in direct contact with the substrate 102 may be substantially (e.g., at least 80% surface coverage) or entirely coated/clad by the second molybdenum layer 804. The first and second cladding layers 802, 804 may be immiscible with or may have low miscibility with respect to the conductive material of the first conductive structures 702 and the second conductive structures 704 at temperatures below 300 °C or at temperatures below 500 °C according to various embodiments.

In one or more embodiments, the first conductive structures 702 and the second conductive structures 802 each include material, such as gold, having a lower boiling point than molybdenum, such that formation of the first molybdenum layer 802 on the first conductive structures 702 causes additional film stress at the overhanging portions, such as the portions 706, causing the overhanging portions to bend further away from the substrate 102, thereby further widening the openings between the overhanging portions. This additional widening of the openings between the overhanging portions of the first conductive structures 702 and the second photoresist layer 502 may advantageously increase the amount of molybdenum that can be deposited on the side surfaces of the second conductive structures 704 (as part of the second molybdenum layer 804).

While the present example refers to the deposition of molybdenum layers 802 and 804, it should be understood that in one or more other embodiments, other materials that are immiscible with or that have low miscibility with the second conductive structures 704 (e.g., with gold) and/or that have higher hardness than the second conductive structures 704 may instead be used, such as tungsten, osmium, ruthenium, iridium, rhodium, or chromium as non-limiting examples.

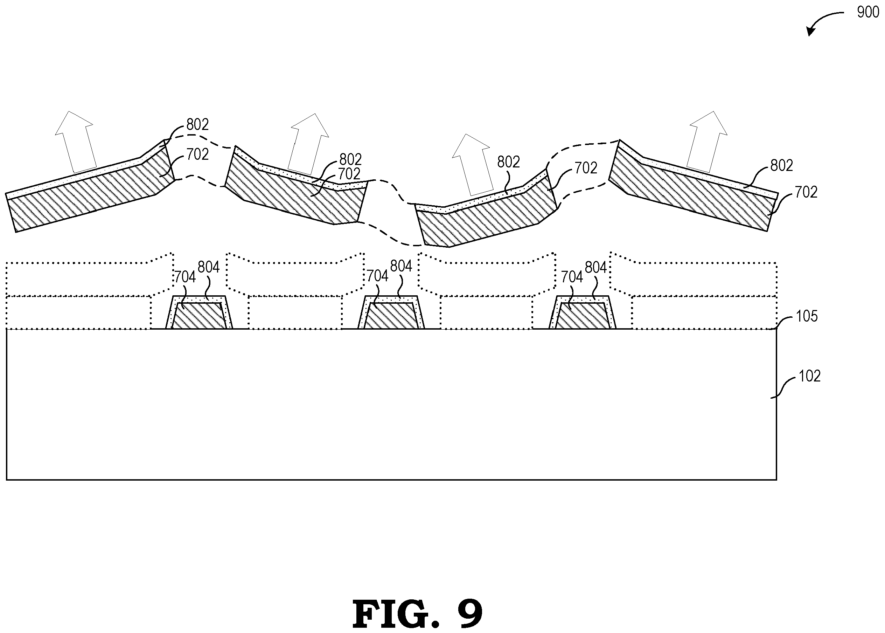

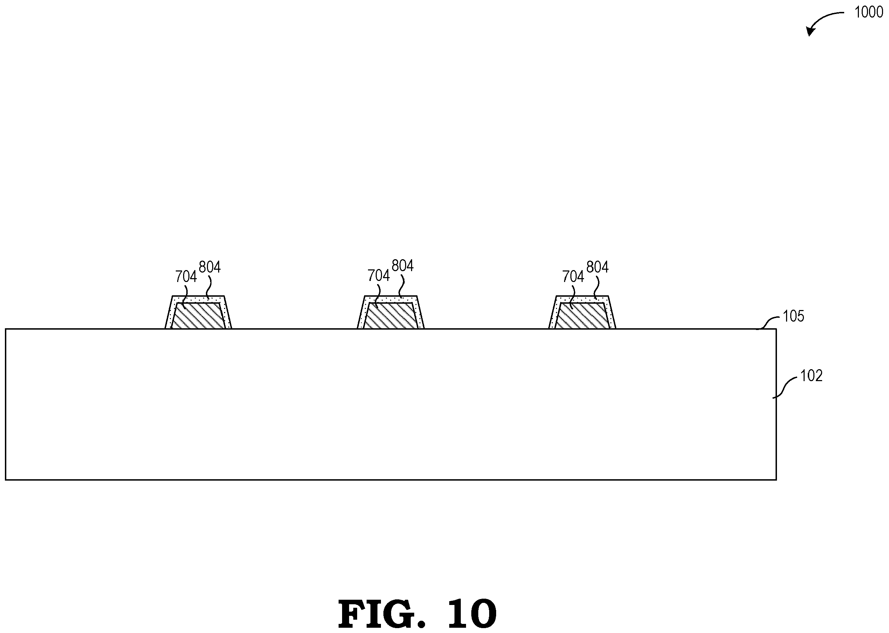

Referring to step 214 of FIG. 2 ("remove first and second photoresist layers to remove portion of cladding layer and conductive structures disposed in the second photoresist layer") and to FIGS. 9 and 10, during a stage of fabrication 900, a lift-off process is performed by which the first and second photoresist layers 402, 502 are removed, resulting in removal of the first conductive structures 702 and the first molybdenum layer 802 that were formed on the second photoresist layer 502. The stage of fabrication 900 illustrates the lift-off of the first conductive structures 702 and the first molybdenum layer 802 upon removal of the first and second photoresist layers 402, 502. As shown, the first conductive structures 702 and the first molybdenum layer 802 may be removed simultaneously via the lift-off process. In one or more embodiments, the first molybdenum layer 802 and the first conductive structures 702 may be connected sheets of material in which openings are formed, as indicated here by dotted lines connecting portions of the first conductive structures 702 and the first molybdenum layer 802.

The stage of fabrication 1000 shows the second conductive structures 704 and the second molybdenum layer 804 that remain following removal of the first conductive structures 702, the first molybdenum layer 802, and the first and second photoresist layers 402, 502. As described previously, by cladding the second conductive structures 704 with the second molybdenum layer 804, conductive elements (e.g., gate electrode, source electrode, drain electrode, or other suitable conductive elements) formed, at least in part, by the second conductive structures 704 may have reduced risks of undesirable mechanical deformation and/or undesirable resistivity increases that may otherwise result from alloying of the second conductive structures 704.

While various examples described above relate to conductive structures (e.g., the conductive structures 604 of FIGS. 7-10 and the conductive material 128 of FIG. 1) that are cladded with molybdenum (e.g., molybdenum layers 802, 804 of FIGS. 8-10 and cladding layers 122, 132, 142, FIG. 1), it should be understood that this is intended to be illustrative, not limiting, and that other suitable cladding materials may be used instead of molybdenum. For example, such cladding materials may include materials that are either immiscible with or that have low miscibility with the conductive material to which the cladding material is applied at temperatures below around 300 °C or below around 500 °C according to various embodiments. Additionally or alternatively, the cladding materials may have relatively high hardness (e.g., hardness above 5 or 5.5 on the Mohs hardness scale)For one or more embodiments in which the conductive structures are formed from gold, such cladding materials may include any of tungsten, osmium, ruthenium, iridium, rhodium, or chromium.

As used herein, the word "exemplary" means "serving as an example, instance, or illustration." Any implementation described herein as exemplary is not necessarily to be construed as preferred or advantageous over other implementations. Furthermore, there is no intention to be bound by any expressed or implied theory presented in the preceding technical field, background, or detailed description.

The connecting lines shown in the various figures contained herein are intended to represent exemplary functional relationships and/or physical couplings between the various elements. It should be noted that many alternative or additional functional relationships or physical connections may be present in an embodiment of the subject matter. In addition, certain terminology may also be used herein for the purpose of reference only, and thus are not intended to be limiting, and the terms "first", "second" and other such numerical terms referring to structures do not imply a sequence or order unless clearly indicated by the context.

The foregoing description refers to elements or nodes or features being "connected" or "coupled" together. As used herein, unless expressly stated otherwise, "connected" means that one element is directly joined to (or directly communicates with) another element, and not necessarily mechanically. Likewise, unless expressly stated otherwise, "coupled" means that one element is directly or indirectly joined to (or directly or indirectly communicates with, electrically or otherwise) another element, and not necessarily mechanically. Thus, although the schematic shown in the figures depict one exemplary arrangement of elements, additional intervening elements, devices, features, or components may be present in an embodiment of the depicted subject matter.

While at least one exemplary embodiment has been presented in the foregoing detailed description, it should be appreciated that a vast number of variations exist. It should also be appreciated that the exemplary embodiment or embodiments described herein are not intended to limit the scope, applicability, or configuration of the claimed subject matter in any way. Rather, the foregoing detailed description will provide those skilled in the art with a convenient road map for implementing the described embodiment or embodiments. It should be understood that various changes can be made in the function and arrangement of elements without departing from the scope defined by the claims, which includes known equivalents and foreseeable equivalents at the time of filing this patent application.

## Claims

1. A transistor device comprising:
a semiconductor substrate having an upper surface;
a control electrode disposed on the upper surface of the semiconductor substrate;
a first current-carrying electrode disposed on the upper surface of the semiconductor substrate; and
a second current-carrying electrode disposed on the upper surface of the semiconductor substrate, wherein at least one of the control electrode, the first current-carrying electrode, or the second current-carrying electrode includes conductive material that is coated with a cladding material, wherein the cladding material has low miscibility with the conductive material.

2. The transistor device of claim 1, wherein the control electrode comprises the conductive material.

3. The transistor device of claim 1 or 2, wherein each of the control electrode, the first current-carrying electrode, and the second current-carrying electrode include the conductive material.

4. The transistor device of any preceding claim, wherein the conductive material comprises gold and the cladding layer comprises molybdenum.

5. The transistor device of claim 4, wherein the cladding layer has a thickness of less than 400 angstroms.

6. The transistor device of claim 4 or 5, wherein the cladding layer is formed on an upper surface and side surfaces of the conductive material.

7. The transistor device of any preceding claim, wherein the semiconductor substrate comprises:
a host substrate;
a buffer layer comprising first semiconductor material formed over the host substrate;
a channel layer comprising second semiconductor material formed over the buffer layer, wherein each of the control electrode, the first current-carrying electrode, and the second current-carrying electrode overlap the channel layer; and
a barrier layer comprising third semiconductor material formed over the channel layer, wherein the upper surface of the semiconductor substrate corresponds to an upper surface of the barrier layer.

8. A method comprising:
forming at least one patterned photoresist layer on an upper surface of a semiconductor substrate;
forming conductive material having first portions formed on the at least one patterned photoresist layer and second portions in openings in the at least one patterned photoresist layer, wherein the second portions contact the upper surface of the semiconductor substrate; and
forming a cladding layer on the conductive material, wherein the cladding layer is harder than the conductive material.

9. The method of claim 8, further comprising:
simultaneously removing each of the at least one patterned photoresist layer, the first portions of the conductive material, and first portions of the cladding layer that are disposed on the first portions of the conductive material via a lift-off process.

10. The method of claim 9, wherein the at least one patterned photoresist layer comprises a first patterned photoresist layer disposed on the upper surface of the semiconductor substrate and a second patterned photoresist layer disposed on the first patterned photoresist layer, and wherein the second patterned photoresist layer overhangs the first patterned photoresist layer at each of the openings.

11. The method of any of claims 8 to 10, wherein the first portions of the conductive material and portions of the cladding layer formed on the first portions of the conductive material correspond to control electrodes of transistor devices.

12. The method of any of claim 8 to 11, wherein the cladding layer has a thickness of less than 400 angstroms.

13. The method of any of claim 8 to 12, wherein the conductive material comprises gold, and the cladding layer comprises molybdenum that is formed directly on the gold of the conductive material.

14. The method of any of claim 8 to 13, wherein forming the cladding layer on the conductive material comprises:
depositing the cladding layer on an upper surface and side surfaces of the conductive material via evaporation.
